# EUROPEAN PATENT SPECIFICATION

(11) **EP 3 096 922 B1**
(45) Date of publication and mention of the grant of the patent: **15.04.2020**
(21) Application number: 15708010.2
(22) Date of filing: 26.01.2015
(51) Int. Cl.: B24C 1/04, B24C 5/04

(54) **COMPOSITE FOCUS TUBES**
ZUSAMMENGESETZTE FOKUSRÖHREN
TUBES DE FOCALISATION COMPOSITES

(30) Priority: 26.01.2014 GB 201401265
(43) Date of publication of application: 30.11.2016
(73) Proprietor: Miller, Donald Stuart, Harrold, Bedford MK43 7DA (GB)
(72) Inventor: Miller, Donald Stuart, Harrold, Bedford MK43 7DA (GB)
(74) Representative: Franks & Co (South) Limited
(86) International application number: PCT/GB2015/000023
(87) International publication number: WO 2015/110789

(56) References cited:
- EP-A1- 1 061 154
- WO-A1-03/011524
- US-A- 4 689 276
- US-A- 5 092 085
- US-A- 5 363 556
- US-A1- 2008 220 699

## Description

### FIELD OF APPLICATION

This invention relates to focus tubes consisting of a chemical vapour deposition diamond tube in a holder for use in a cutting head of an abrasive waterjet cutting machine.

### BACKGROUND

In a cutting head of an abrasive waterjet cutting machine a high speed waterjet entrains abrasive particles in a carrier fluid into a focus tube bore where momentum is exchanged between a waterjet and abrasive particles to generate a cutting jet at the focus tube outlet. Focus tube bore length to diameter ratios are typically in the range of 80 to 120 and are drilled by electrical discharge machining (EDM). For the efficient entrainment of particles into a focus tube bore, a tapered inlet is machined into an inlet end of the focus tube bore.

The current best performing focus tubes are made from a monolithic elongated cylinder of proprietary tungsten carbide that contains virtually no binder material; examples of such tubes are sold under the brand name ROCTEC® by Kennametal Inc., Latrobe, Pa., U.S. These focus tubes have a hardness of about 28GPa and typically have a life of 40 to 80 hours when cutting with garnet abrasive with a hardness of 13GPa or so. Focus tubes with longer lives would provide considerable benefits from higher cutting machine availability and fewer problems with parts going out of tolerance.

For effective cutting it is necessary to use abrasive that is 1.2 or so times harder that the material being cut, which means a variety of high value difficult to machine engineering ceramics and composites cannot be economically cut using garnet abrasive. When cutting with aluminium oxide, which has a hardness of 20GPa, tungsten carbide focus tubes have a useful life of an hour or so and only minutes when silicon carbide abrasive with a hardness of 28GPa is used. There is a need for focus tubes capable of hours of cutting with abrasive having a hardness up to 28GPa.

Sintered polycrystalline diamond (PCD) and chemical vapour deposition diamond (CVDD) are much more wear resistant than tungsten carbide. The benefits that would accrue from the use of diamond focus tubes are so evident that numerous attempts have been made, over more than twenty years, to manufacture diamond focus tubes, but diamond focus tubes have yet to be commercially exploited.

Focus tubes cannot be made from a monolithic piece of PCD or CVDD because of constraints on the size of PCD and CVDD pieces that can be manufactured. A two or more part construction of a diamond focus tube is therefore necessary. In US Patent Application No US2010/0088894, the patent literature related to the manufacture of multi-part diamond focus tubes is reviewed and a method of manufacture disclosed aimed at reducing the high cost of manufacturing multi-part focus tubes.

The majority of multi-part diamond focus tubes yet proposed have one or more joints in the bore, either longitudinally or radially. Joints are locations of weakness that are attacked by high speed abrasive particles unless the joints are extremely precise, which is costly to achieve because of the difficulty of machining diamond. Focus tubes with joints in their bores have precision machined surfaces to locate components relative to one another and the components are held together using a variety of methods including shrink and force fitting, clamping brazing, soldering and adhesives.

Growing a CVDD tube on a wire or former and etching away the wire or former is a prior art method of making focus tubes without joints in a bore. CVDD tubes have been grown on wires and fibres with diameters as small as 25 microns and the wires and fibres successfully etched out. There is, therefore, the potential to produce CVDD focus tubes down to 25 microns bore diameter or less. Because CVDD growth rates are only 1µm or so per hour, CVDD tube thickness needs to be held to the minimum necessary to allow the transfer of momentum from a high speed waterjet to abrasive particles, without tube failure. A tube that fulfils this function is relatively thin and is easily damaged by exterior forces and must be protected in a holder, forming what is referred to herein as a composite focus tube.

Extensive work was carried out ("GE series") in the 1990s by the General Electric Company, Worthington, Ohio, to develop CVDD composite focus tubes. The patents granted for the GE series disclose problems encountered and attempts to overcome CVDD tube failures. In US Patent No US5175929, it is described how to grow CVDD tubes with an integral tapered inlet to a bore, it being a considered impractical to machine a tapered inlet to a bore. In US Patent No US5363556, on which the preambles of claims 1 and 14 are based, it is described how a CVDD tube with its integral tapered inlet is put under radial compressive loading by thermally shrinking a casing around the CVDD tube in order to overcome tube failures - CVDD tube failures that were thought to be caused by compressive stress waves reflecting from the outer surface of a diamond tube as tension waves.

Another in the GE series, US Patent No US5387447, describes how growth rates vary with location within a reactor in which CVDD was grown, resulting in tube wall thicknesses varying significantly circumferentially around a tube. An apparatus for substantially overcoming this problem by continuous rotation and movement of the growing CVDD tubes in a reactor is described. In practice, though, such a mechanism is difficult and expensive to implement and does not overcome local variations in diamond thickness due to the competitive nature of the diamond grain growth process and variations in diamond growth rates with longitudinal position in a reactor.

Another in the GE series, US Patent No US5468934, describes a method of annealing diamond focus tubes to relieve stresses induced by the growth process. It was postulated that failures caused by abrasive jets perforating the side wall near the midpoint location were the result of the intrinsic diamond deposition stresses. Perforation of focus tubes near the midpoint is now predominately associated with misalignment of a focus tube relative to a waterjet.

The GE series patents do not disclose how alignment of the focus tube bore centrelines with the centrelines of waterjets was achieved. At the time of the GE series patent filings, the alignment of a focus tube centreline with a waterjet was problematic even for monolithic tungsten carbide focus tubes in which the bore was drilled by EDM on the centreline of a ground tungsten carbide cylinder. The form of the GE series composite focus tubes with non-uniform diamond wall thicknesses and external layers applied by plasma deposition or metal spraying or casting would have made achieving alignment, to the accuracies required to avoid premature tube failures, even more challenging than with monolithic tungsten carbide focus

Alignment of a focus tube bore centreline to the centreline of a waterjet within microns is important for the effective generation of abrasive cutting jets, particularly for micromachining. As an example the diameter of a waterjet when it enters a 100 micron diameter focus tube bore would typically be 50 microns thus giving a mean annulus width between the waterjet and bore wall at entry of 25 microns. A 5 micron misalignment between the centreline of the waterjet generating device and the centreline of a focus tube results in the annular gap varying between 20 and 30 microns. The consequence of such a variation is uneven entrainment of abrasive around a waterjet, loss of cutting performance and localised focus tube wear. Because of the growth conditions and growth process circumferential variations in wall thickness of CVDD tubes far exceed the allowable tolerance on centreline alignments. Means must be provided for a CVDD focus tube to be held in a holder so that centreline of the focus tube is essentially coincident with the centreline of the holder.

The GE series patents do not disclose the experimental set up for testing the composite CVDD focus tubes but it could be expected that they were typical of those existing in the abrasive waterjet industry at that time. Improvements in ultrahigh pressure pumps and the use of lower focus tube bore diameters to waterjet diameters have allowed abrasive cutting jet energy densities to be more than doubled since the time of GE series patent filings. CVDD diamond focus tubes must be capable of withstanding forces generated by higher abrasive particle flow energy densities.

The GE series patents do not describe if and how the material surrounding a composite CVDD focus tube was protected against a reflected cutting jet. During drilling into a workpiece, a jet is reflected back on to a focus tube with little loss of cutting power. Focus tubes made of tungsten carbide have an outside diameter that is typically five to ten times the bore diameter so that a reflected jet impacts and is deflected by the end of a tube. Because of the cost and difficulty of growing CVDD diamond tubes, the diamond part of a composite focus tube is typically about twice the bore diameter and surrounded by poor erosion resistant material compared to diamond. Means of accommodating cutting jet reflection must be provided by the design of composite focus tubes and the cutting heads in which they are installed.

It is known that cutting performance of a focus tube with a simple conical tapering inlet can initially improve and then go into a steady decline until a wear front, progressing from the inlet to the outlet, reaches a focus tube outlet and the cutting jet diameter rapidly goes out of tolerance. Because of the relatively short period when erosion of the inlet region improves cutting performance it is not economic to machine an inlet, in tungsten carbide focus tubes, that replicates the initial wear shape.

The development of technologies for milling with abrasive waterjets is proving extremely difficult because as a cutting jet is traversed across a workpiece surface it produces a generally V shaped groove. The V shaped grove is the result of the number of abrasive particle impacts decreasing to essentially zero at the jet periphery at right angles to the direction of cutting jet travel. On subsequent traverses a jet tends to be deflected by the walls of a V shaped groove so that it is not possible to programme cutting head movements to produce low roughness milled surfaces. A rectangular cross section cutting jet could be more easily controlled to produce a low roughness surface, provided the distribution of abrasive in the cutting jet was uniform. Methods of drilling focus tube bores in tungsten carbide require the cross section of a bore to remain essentially the same shape from inlet to outlet. It has been found that in trials of tungsten carbide focus tubes with square cross-sectional bores that cutting jets are generated that have a high concentration of particles at the corners of the jet, which causes a different set of serious problems to those from milling with a round jet. It is therefore desirable to vary a bore cross-section along its length to produce non-circular cutting jets with an even particle distribution.

### SUMMARY OF THE INVENTION

Composite CVDD focus tubes to this invention avoid problems described above to provide economic tube lives when passing abrasive harder than garnet. Also the composite tubes provide improved cutting performance and can generate cutting jet cross-sectional shapes appropriate for milling.

In this invention a CVDD tube is positioned and retained in a holder by a means that does not impose significant forces on the diamond tube, that is to say the diamond tube is held in a soft manner. Although intuitively a hard fixing method would seem desirable it is considered that the hard fixing used by prior art contributed to or was the cause of prior art composite CVDD tube failures.

CVDD tubes for use in this invention can be grown by processes that result in columnar microstructures. Diamond grains grow competitively resulting in wide variations in grain size and shape with grains being outcompeted by adjacent grains so the number of grains decreases and grain size increases as tube wall thickness increases. The resulting material has numerous faults and weakness along and close to grain boundaries. The growth surface that forms the outside of a tube is rough, angular and faceted.

Bonding between grains at the nucleation surface of CVDD is extremely high so abrasive particle impacts do not tend to cause intrinsic faults in the diamond to propagate but near the growth surface, with wall thickness required for focus tubes, intrinsic flaws propagate if grains are subject to significant forces. It is considered that applying a radial compressive force to the rough, angular and faceted surface of a CVDD tube, as in prior art holding practice methods, would inevitably result in shear and bending forces occurring at the level of individual diamond grains leading to propagation of cracks from the faults already existing at or close to grain boundaries. Also it is considered that the miss-match between the thermal expansion coefficient of diamond and that of braze material and a holder causes longitudinal shrinkage movements during cooling with hard fixing methods that generate tension forces between individual and groups of grains, thus further exacerbating the growth of existing faults. It is know that groups of grains can be pulled out of cut edge when wire EDM cutting conducting CVDD, illustrating that the forces needed to cause failure along grain boundaries are relatively small. Prior art practice of compressive loading on diamond tubes by thermal shrinkage of higher thermal expansion coefficient material around a diamond tube is likely to have caused boundary cracks and intrinsic faults to propagate.

Brazing is the preferred method of making a strong metal to diamond holding joint. Based on experience of brazing diamond to a number of substrates it is considered that substantial lateral and radial forces are present along high length to diameter CVDD tubes after brazing. These forces arise from preferential migration of braze material to particular sites in a brazed joint during the braze solidification phase. The reason for this migration is not understood but is considered to be related to the complex chemical reactions involved in forming a brazed joint to diamond. Because of varying brazing gap width the potential for braze migration would be high when fixing CVDD tubes with the variations in wall thickness inherent in growing CVDD tubes. Forces generated whilst making a brazed joint are much higher than those that can be imposed to fixture a CVDD tube to locate the centreline of the tube bore relative to the centreline of a holder.

A reason for selecting a hard fixing method is to intimately couple a CVDD focus tube to a material that has acoustic impedance similar to or higher than diamond. By matching material acoustic impedance stress waves from particle impacts are transmitted rather than reflected as tension waves; it being known that CVDD diamond when impacted by high speed water droplets fails under tension from stress waves reflected from the non-impact surface. A CVDD tube may be surrounded by a tungsten carbide holder with higher acoustic impedance than diamond but in practice available materials for forming a bond between diamond and tungsten carbide transmit little stress wave energy. An exception to this is gold but its use is ruled out on cost as well as the impracticability of making a sound joint and holding a CVDD tube centreline relative to a holder reference centreline whilst making a joint.

Focus tube bore wear is the result of a million or so particles per second travelling at up to twice the speed of sound making a number of glancing impacts on a bore wall as they pass through a focus tube bore. The individual impact forces are small compared to the strength of high quality CVDD diamond of appropriate thickness, both as regards the compressive and reflected tensile stress waves. This has shown be true by experiments on which this patent is based provided that the following criteria are met:
a CVDD tube is not subjected to substantial exterior forces from the method of holding a tube in a holder.
a CVDD tube has an appropriate wall thickness for its bore diameter.
a CVDD tube bore centreline is accurately aligned with the centreline of the waterjet generating device.

The diamond tubes incorporated into composite focus tubes to this invention can be grown on wires or formers by all known CVD diamond growth processes. These growth processes include doping with boron or other suitable dopant to make the diamond electrically conducting so that it can be processed by electric discharge machining (EDM).

CVDD diamond tubes for use in this invention can be grown on formers, wires or tubes that are made of materials that those skilled in the art of CVDD diamond production have proven to be suitable, such as silicon, silicon carbide and a range of carbide forming metals including molybdenum and tungsten. CVDD diamond can be grown on a long rod, wire or tube and material for individual CVDD tubes cut from the resulting CVDD tube either before or after the wire or tube is removed or they can be grown on formers. A former may take the form of a rod, tube or wire appropriately etched, ground or otherwise treated along its length to form individual tube shapes so as to grow a number of CVDD tubes with individual tubes subsequently cut from the grown CVDD material. A former may be made by 3D printing using tungsten or other suitable material. Wires and formers can be removed by acid etching, EDM, electro chemical machining, abrasive waterjet machining or any combination of these or other methods.

The preferred machining of CVDD diamond tubes for this this invention is by laser machining unless the CVDD is electrically conducting when machining can be by EDM or laser or a combination of both methods. In implementations of this invention a tapering inlet is machined into the wall of a CVDD tube.

The variation in circumferential wall thickness of the CVDD tubes for this invention can exceed 100% of the bore diameter but is preferably is less than 25% of the bore diameter and more preferably less than 10%. At the location of minimum CVDD tube wall thickness the wall thickness is preferably greater than 50% of the tube bore diameter and more preferably greater than the bore diameter.

In implementations of this invention the tapering inlet to a focus tube bore is shaped during the CVDD growth process on a former such that the transition to the bore takes place over an extended length of a focus tube compared to that which is practical when EDM machining tungsten carbide focus tubes. This allows for the initial violent interaction between a high speed waterjet and abrasive particles to occur in a more favourable manner than in prior art focus tubes.

To generate a non-circular cutting jet, and in particular an essentially square cross-section cutting jet for milling, the cross-sectional shape a former on which a CVDD focus tubes is grown can vary along a former in order to grow CVDD tubes with cross-sectional shapes that vary from inlet to outlet in a manner to provide desirable distribution of abrasive particles in a non-circular cutting jet.

CVDD focus tubes to this invention are positioned in and retained in a holder in an essentially stress-less manner. In some implementations a holder is machined or formed from a single piece of material whilst in other implementations a holder is an assembly of two or more elements. In other implementations the holder is also the body of a cutting head. That part of a holder to this invention that is subjected to abrasive erosion from a cutting jet reflected from a workpiece is preferably made of a tungsten carbide, Polycrystalline diamond or other highly erosion resistant material.

A position-holding-fixing procedure is used in implementations of this invention to locate and retain a CVDD tube so that its bore centreline is on the reference centreline of a holder. A position-holding-and-fixing procedure involves locating a CVDD tube in its holder using a jig that has location pins or a wire or other location means to position and hold the centreline of the CVDD tube bore on the holder reference centreline whilst an encasing material solidifies, sets or cures or otherwise hardens.

Another position-holding-fixing procedure to this invention involves locating a CVDD focus tube in a mould such that the centreline of the tube is held on the centreline of an elongated bore in the mould whilst an essentially non stressing encasing material solidifies, sets or cures or otherwise hardens. The encased focus tube is then removed from the mould and held in the bore of a holder.

The preferred materials for encasing and holding a CVDD focus tube are polymers and in particular polymer adhesives. The characteristics of adhesives can include: rapid setting; good heat and/or electrical conductivity; high strength and/or erosion resistance. Encasing and holding of a tube in a holder may be carried out in two or more stages. The initial encasing and holding of a CVDD tube in position in a holder over part of its length is can be carried out using a rapid setting or curing adhesive. A second or further encasing and holding processes can be made using a polymer or other material with additives such as ceramic particles that provided erosion resistance of the encasing material.

Polymers selected for implementations of this invention have gap filling capabilities appropriate to variations in joint gap width caused by circumferential variations in CVDD tube wall thickness and by surface roughness. To accommodate substantial variation in the circumferential wall thickness of a CVDD tube wall, the bore in a holder in which a CVDD tube is to be located and held can be offset relative to the reference centreline on the holder to which the CVDD tube centreline is referenced.

An alternative method of encasing and holding a CVDD tube in a holder to this invention, while the tube is held so that its centreline is coincident with a holder reference centreline, is by the use a fusible metal alloy or solder material. A fusible alloy that expands on solidification is preferably used to fill the cavities on the outside of a CVDD tube without causing significant stress on the diamond. A solder or fusible alloy joint may be used in conjunction with an adhesive joint for holding and fixing a CVDD tube in a single or in a multi-component holder.

In implementations of this invention part of the length of a CVDD focus tube may be unsupported by a holding and fixing material either prior to installing of a composite CVDD focus tube in a cutting head or because part of the encasing and holding material at the inlet or outlet end of a focus tube is eroded away by abrasive particles during operation of a cutting head.

In implementations of the invention the holder is machined from a monolithic piece of superhard material that is not excessively eroded by an abrasive jet turning back on itself during drilling into a workpiece. In other implementations a superhard material section is attached to the main body of a holder at its outlet end or to a cutting head body, to minimise damage.

In implementations of this invention an erosion resistant protector is provided prior to the tapered inlet to a CVDD focus tube to protect the CVDD tube encasing and holding material from erosion at that location.

According to the present invention, there is provided a composite chemical vapour deposition diamond (CVDD) focus tube for a cutting head of an abrasive waterjet cutting machine, said composite CVDD focus tube comprising:
an elongate CVDD tube having a smooth through bore extending longitudinally between an inlet end of the CVDD tube and an outlet end of the CVDD tube; and
holder means having an elongate passage extending through the holder means to accommodate the elongate CVDD tube;
wherein the elongate CVDD tube is encased within said elongate passage by a solid castable material, said castable material being deliverable into said passage as a liquid for subsequent solidification.

In a first preferred embodiment, said castable material solidifies by undergoing chemical reaction.

Advantageously, said castable material comprises a plastics material curable in situ within said passage.

Said castable material may comprise an adhesive composition.

Said castable material may comprise a toughened adhesive composition, optionally reinforced with solid particles, such as particles of ceramic or polymeric material.

Said adhesive composition may comprise one or more of a cyanoacrylate adhesive, an epoxy adhesive and/or a urethane adhesive.

Alternatively or additionally, said castable material solidifies by undergoing a phase change on cooling.

Advantageously, said castable material then comprises a metal, optionally a metal alloy.

Said castable material may comprise a fusible alloy, optionally having a melting point of 200°C or below.

An outer surface of the elongate CVDD tube may be coated with metal to enhance wetting of said outer surface by the castable material in liquid form.

Preferably, the through bore of the elongate CVDD tube comprises a generally conical portion tapering from said inlet end to meet a remainder of the bore, said remainder of the bore optionally having a substantially constant diameter.

The elongate CVDD tube is preferably so held within the passage of the holder means that a longitudinal axis of the through bore of the elongate CVDD tube coincides with a reference centreline of the holder means.

A wall thickness of the elongate CVDD tube may vary circumferentially and/or longitudinally.

An outer surface of the elongate CVDD tube is preferably rough and faceted, so as to engage with the castable material encasing the elongate CVDD tube within the passage.

The castable material may be selected such that when solidified around the elongate CVDD tube, it holds the elongate CVDD tube without exerting significant stress thereon.

The holder means may comprise a body of the cutting head of the abrasive waterjet cutting machine.

The composite CVDD focus tube may comprise passageway means leading to the inlet end of the CVDD tube, optionally extending through the holder means, said passageway means being adapted to deliver abrasive particles in a carrier fluid into the bore of the elongate CVDD tube.

Said passageway means and the inlet end of the CVDD tube may together be profiled to guide abrasive particles into the inlet end of the CVDD tube, such that said abrasive particles are generally evenly distributed around a circumference of the through bore at the inlet end of the CVDD tube.

The diamond of the elongate CVDD tube may be doped, optionally with boron, to render the diamond electrically conductive.

The through bore of the elongate CVDD tube may have an internal profile that varies along its length towards the outlet end of the CVDD tube, so as to project a non-circular section waterjet from said outlet end.

According to the present invention, there is provided a method of making a composite CVDD focus tube for a cutting head of an abrasive waterjet cutting machine, comprising the steps of:
providing an elongate CVDD tube having a smooth through bore extending longitudinally between an inlet end of the CVDD tube and an outlet end of the CVDD tube;
providing holder means having an elongate passage extending through the holder means to accommodate the elongate CVDD tube;
locating the elongate CVDD tube into said elongate passage; and
delivering a castable material in liquid form into the passage, external to the elongate CVDD tube, then causing the castable material to solidify.

Preferably, the elongate CVDD tube is located within said passage in the holder means such that a longitudinal axis of the through bore of the elongate CVDD tube coincides with a reference centreline of the holder means, and is held in this location until the castable material has solidified.

The CVDD tube on its outer diameter may be encased in an essentially stress free manner and held in the bore of the holder

The centreline of the bore of a CVDD focus tube may be aligned and held to be coincident with a reference centreline of the holder whilst encasing material which is also the holding material solidifies, sets, cures or otherwise hardens.

The centreline of the bore of a CVDD focus tube may be aligned and held to be coincident with a reference centreline of a bore in a mould whilst a non-stressing encasing material solidifies, sets, cures or otherwise hardens and the encased CVDD focus tube removed from the mould and held in the bore of the holder of the first aspect.

The CVDD focus tube may be encased in an essentially stress free manner in polymer or metal or a combination of polymer and metal.

The encasing and holding material may be a cyanoacrylate or epoxy or urethane adhesive.

The holder may be also the body of an abrasive waterjet cutting head.

The wall thickness of the CVDD tube may vary circumferentially and/or longitudinally.

A passageway may be machined into the inlet end of the holder for the flow of abrasive particles in a carrier fluid.

The walls of the passageway may be shaped to guide abrasive particles so that they enter the generally tapering inlet to a focus tube bore reasonably evenly distributed around the periphery of the inlet.

The CVDD tube may be doped to make the diamond electrically conducting.

The generally tapering inlet to the CVDD tube may be machined into the wall of CVDD tube by laser unless the diamond is doped with boron or other dopant to make the diamond electrically conducting when the inlet can be laser or electric discharge machined.

The cross-sectional shape of the bore of a CVDD focus tube may be varied along its length to generate a non-circular shaped jet with a desirable particle distribution at the focus tube outlet.

Particular embodiments of the present invention will now be described by way of example and with reference to the accompanying drawings, in which:
**Figure 1** is a longitudinal cross-sectional elevation of a first composite CVDD focus tube embodying the present invention;
**Figure 2** is a longitudinal cross-sectional elevation of a second composite CVDD focus tube embodying the present invention, in which the CVDD tube is of varying wall thickness;
**Figure 3** is a longitudinal cross-sectional elevation of a jig for assembling composite CVDD focus tubes embodying the present invention;
**Figure 4a** is a longitudinal cross-sectional elevation of a third composite CVDD focus tube embodying the present invention, in which the bore is of varying cross-sectional profile;
**Figure 4b** is an enlarged scrap view of an upper portion of the CVDD tube of the focus tube shown in Figure 4a;
**Figures 4c to 4e** are scrap radial cross-sections at different points of the bore of the CVDD tube of the focus tube shown in Figure 4a;
**Figure 5a** is a longitudinal cross-sectional view of a fourth composite CVDD focus tube embodying the present invention, provided with erosion-resistant portions at each end;
**Figure 5b** is a longitudinal cross-sectional view of a fifth composite CVDD focus tube embodying the present invention, also provided with erosion-resistant portions at each end;
**Figure 6** is a longitudinal cross-sectional view of a cutting head body of an abrasive waterjet cutting tool also acting as a holder for a CVDD tube embodying the present invention;
**Figure 7a** is a schematic longitudinal cross-sectional view of a CVDD focus tube being encased in a mould, according to a method embodying the present invention; and
**Figure 7b** is a scrap radial cross-section of the CVDD tube and mould shown in Figure 7a.

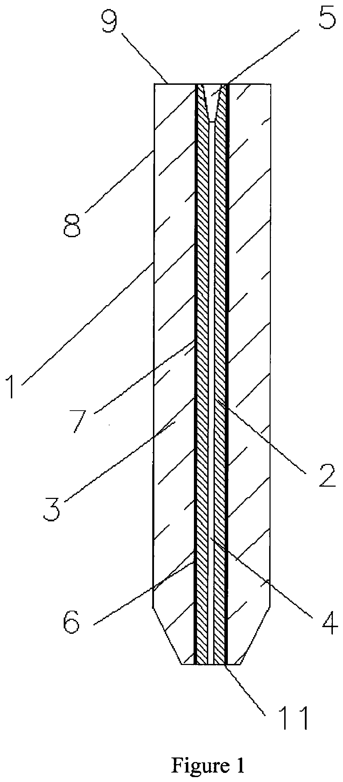

Referring now to the Figures, and to Figure 1 in particular, a first composite chemical vapour deposition diamond (CVDD) focus tube 1 comprises an elongate CVDD tube 2 having a longitudinal through bore 4 with a converging tapered inlet 5 at its inlet end, the CVDD tube 2 being securely retained in a passage extending through a holder 3 by an encasing/holding material 7 (details below). The encasing/holding material 7 fills an entire volume between an outer-surface of the CVDD tube 2 and an inner wall of the passage 6.

The holder 3 has a precisely-formed constant outer diameter 8 defining an axial centreline of the holder 3. An axial centreline of the longitudinal through bore 4 of the CVDD tube 2 is precisely aligned with this axial centreline of the holder 3 during manufacture (see below). The holder 3 has a flat inlet face 9 extending level with an inlet end of the CVDD tube 2, while a tapered outlet end of the holder 3 and an outlet end of the CVDD tube 2 together form an outlet end 11 of the composite focus tube 1. The holder 3 is preferably made from a superhard material such as tungsten carbide.

The CVDD tube 2 is conventionally produced, being made by diamond deposition on to a support wire, which is subsequently etched away to leave a smooth through bore 4 surrounded by CVDD walls. An outer surface of the CVDD tube 2 remains as grown, being rough, angular and faceted due to the growth habits of the crystals forming the walls of the CVDD tube 2.

The encasing/holding materials 7 that have been found useful in the present invention include polymers and low-melting-temperature metals or alloys. When the encasing/holding material 7 comprises a low-melting-temperature metal or alloy, the outer surface of the CVDD tube 2 may need first to be coated with a material that aids wetting by the metal or alloy. For example, a thin coating of electroless nickel over the CVDD outer surface has been found to be of value. The polymers used (to date) are capable of wetting and coating a CVDD surface without such pre-treatment.

The polymers that have been used in this application include what are commonly known as instant and structural adhesives, and include cyanoacrylates, epoxies and urethanes. Adhesives toughened by incorporation of solid particles of polymer, ceramic or other such additions are preferred, since these tend to have desirable properties such as enhanced shock, erosion and/or weather resistance.

Suitable low-melting point metals and alloys are believed to include the alloys generally referred to as solders, with "low-melting point" in this context indicating below 450°C (one definition of a boundary between soldering and brazing materials) or preferably below 200°C. It is possible to select such alloys which do not significantly expand or contract significantly as they solidify, avoiding exerting stress on the CVDD tube 2. Alloys with high bismuth contents are believed to be beneficial.

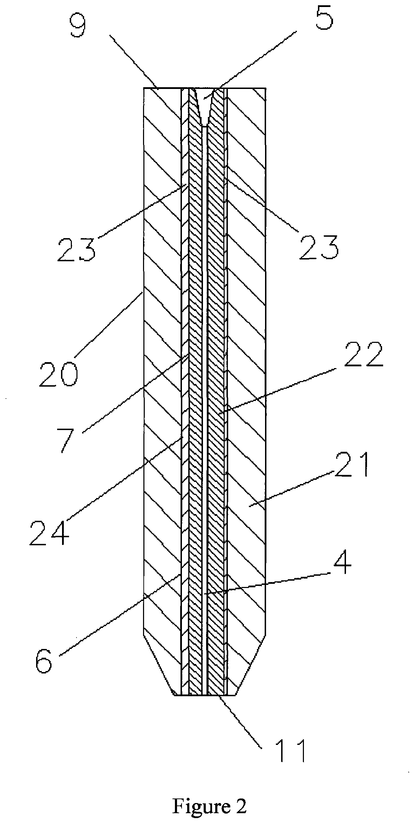

The first composite focus tube 1 shown in Figure 1 comprises a CVDD tube 2 of constant wall thickness, whereas a more usual configuration is shown in Figure 2. Here, an elongate CVDD tube 22 of varying wall thickness around its circumference is held in a holder 21, to form a second composite focus tube 20.

The CVDD tube 22 is encased and held in a longitudinal passage 23 through the holder 21 by an encasing/holding material 7 comprising any of the encasing/holding materials 7 described above in respect of Figure 1. As with the first composite focus tube 1, the second composite focus tube 20 has the centreline axis of the through bore 4 of the CVDD tube 22 precisely aligned with a centreline axis defined by the outer surface of the holder 21. The thickness of the encasing/holding material 7 within the passage 23 thus varies inversely with a local wall thickness of the CVDD tube 22.

The minimum wall thickness of the CVDD tube 22 is preferably greater than half the diameter of the trough bore 4, but more preferably it is greater than the entire diameter of the through bore 4.

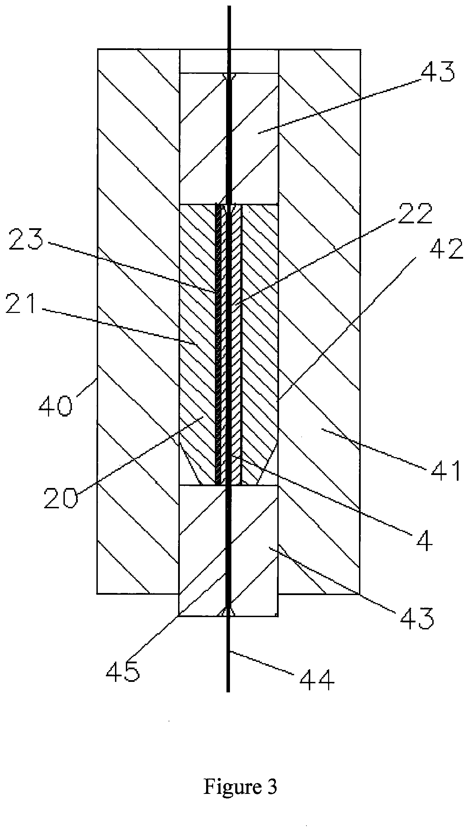

Figure 3 shows a jig 40 for locating a CVDD tube 22 within such a holder 21, while it is fixed in place using the encasing/holding material 7. A typical assembly and fixing method begins with preparing an external surface of the CVDD tube 22 and an internal surface of the passage 23 through the holder 21, as necessary for the materials involved. A wire 44 is positioned to extend through the bore 4 of the CVDD tube 22, and encasing/holding material 7 in liquid or part-solidified form is applied to the CVDD tube 22 and/or the inner surface of the passage 23. The CVDD tube 22 is then inserted longitudinally into the passage 23 through the holder 21.

Next, guide blocks 43, provided with guide bores 45 configured to receive the wire 44, are threaded on to the wire 44 at each end of the holder 21. The guide blocks 43, holder 21 and CVDD tube 22 are together loaded into a channel 42 extending through a body 41 of the jig 40. The wire 44 fits tightly within the bore 4 of the CVDD tube 22, and within the guide bore 45 of each guide block 43, but with sufficient leeway that the CVDD tube 22 and the guide blocks 43 can slide longitudinally along the wire 44. NB: preferably, the wire 44 and all surfaces of the guide blocks 43 have a surface coating to prevent the encasing/holding material 7 adhering to them (e.g. a fluorinated coating should reduce adhesion by many polymeric adhesives).

The wire 44 is maintained in tension, which ensures that the centreline axis of the bore 4 of the CVDD tube 22 is held in position, coinciding with the centreline axis of the holder 21 and of the passage 23 through the holder 21, whatever the external diameter/profile of the CVDD tube 22.

The encasing/holding material 7 is then allowed to solidify/set in the passage 23 around the CVDD tube 22. The jig 40 and wire 44 are removed to yield the second composite CVDD focus tube 20 as shown in Figure 2.

In an alternative embodiment (not shown) the wire 44 is replaced by elongate locating pins extending axially, one from each guide block, into respective ends of the bore 4 of the CVDD tube 22. This arrangement is particularly suitable when the bore 4 has a diameter of greater than 0.3mm, such that locating pins of the appropriate diameter to fit the bore 4 will have adequate strength and rigidity to provide reliable alignment and not to be easily damaged.

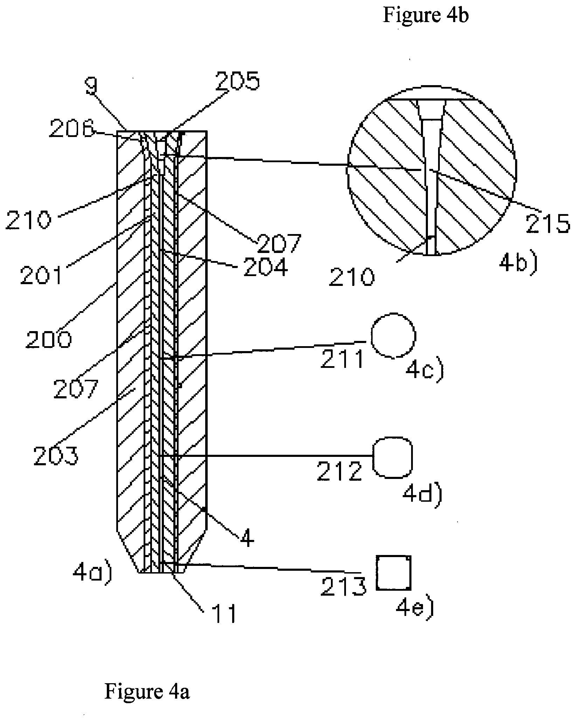

In Figure 4a, a third composite focus tube 200 is shown, generally similar to the second composite focus tube 20, but which comprises a CVDD tube 201 in which a converging tapering inlet 205, leading to its longitudinal through bore 204, has been formed during the process of growing the CVDD tube 201.

In order to accommodate the tapering inlet 205 of the CVDD tube 201, holder 203 of the third composite focus tube 200 has a corresponding converging tapering section 206 at an inlet end of the passage through the holder 203. As above, the CVDD tube 201 is held and fixed within the passage through the holder 203 by an encasing/holding material 207 (corresponding to encasing/holding material 7 above) by a similar method as set above for the second composite focus tube 20.

Figure 4b shows the tapering inlet 205 of the CVDD tube 201 in more detail, in an example where this approach has allowed the formation of an extended tapering inlet profile 215 that approximates to the profile to which tungsten carbide tubes typically wear in their first few hours of operation, when their cutting performance is at a maximum. The fluid dynamics of passage of cutting fluids in such an inlet region are still poorly understood. It is known that in a bore of a focus tube the static pressure falls below that needed to cause airflow into the focus tube bore to choke, with sonic velocity occurring at a throat section. With a waterjet travelling at over twice the speed of sound along the centreline of the bore, and with a gradual contraction in cross-sectional diameter of the inlet, choking in a conventional sense probably does not occur. Whether or not for this reason, the process of momentum transfer from such a waterjet to abrasive particles is known to improve with a more gradual transition in profile 215 from a conical tapering inlet 205 to a constant bore 4 diameter focus tube, as in Figure 4b.

For convenience, the CVDD tube 201 shown in Figure 4a is also shown with a bore 204 of varying cross-sectional profile (this feature and the inlet profile 215 may be used separately or together, as desired). This is achieved by growing the CVDD tube 201 on a shaped former, with the aim of producing an abrasive cutting jet at the outlet end 11 of the composite focus tube 200 that is non-circular, and as a result has a desirable abrasive particle distribution within the jet.

Between an inlet end 210 of the bore 204 (Figures 4a, 4b) and an intermediate point 211 (Figures 4a, 4c), the cross-section of the bore 204 is circular, which provides efficient momentum transfer from a waterjet to abrasive particles.

From intermediate point 211, through lower point 212 (Figures 4a, 4d) to point 212 adjacent the outlet 11 (Figures 4a, 4e), the cross-sectional profile of the bore 204 gradually transitions to a desired cutting jet cross-sectional profile, which in the example shown is a square cross-section. The distance from 211 to 213, over which the transition between circular and square cross-section takes place, can be optimised to control any tendency for abrasive particles to concentrate at internal corners of the bore 204, so as to provide an abrasive cutting jet that can be manipulated to generate an essentially flat milled surface on a workpiece.

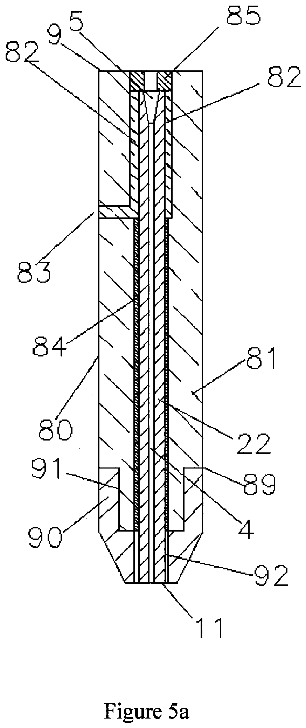

Figure 5a shows a fourth composite focus tube 80, which is provided with an outlet where protection element 90 at the outlet end 11 of the fourth focus tube 80, as well as an inlet protection element 85, at an inlet end 9 of the fourth focus tube 80. The fourth focus tube 80 comprises the same CVDD tube 22 as described above, which is encased and held within a holder 81 of the fourth focus tube 80, using two different encasing/holding materials, 82 and 84. Typically, the encasing and holding of the CVDD tube 22 along its distal portion, towards the outlet end 11, using encasing/holding material 84, would be carried out as described above in relation to the second composite focus tube 20 of Figures 2 and 3. The encasing/holding material 84 preferably comprises a quick-setting toughened adhesive material with a relatively low viscosity. This provides for rapid holding and fixing of the CVDD tube 22, with its centreline axis coincident with the centreline axis of the holder 81, while still comprising an encasing material having adequate strength and shock-absorbing capacity.

If, as is often the case, the tapering inlet 5 of the CVDD tube 22 is formed by machining, after the CVDD tube has been fixed into the holder 81, the encasing/holding material 82 would be selected for specific qualities such as high heat conduction (NB: boron doping of the CVDD material will render it conductive, permitting the use of EDM to machine the CVDD material). Additionally, if the inlet protection element 85 is not used, the encasing/holding material 82 should be selected for high erosion resistance. A typical encasing/holding material 82 is a ceramic or metal-filled wear-resistant epoxy composition. Such epoxy compositions usually have a relatively high viscosity. It may then be necessary for the epoxy composition to be injected under pressure into the volume between the outer wall of the CVDD tube 22 and the inner wall of the holder 21, and in this example a lateral passageway 83 is provided for injection of the epoxy composition.

A reflected jet, bouncing back from a workpiece during cutting or milling with an abrasive waterjet, has sufficient cutting power rapidly to erode any material that is not a superhard material. If a superhard abrasive material, such as aluminium oxide or silicon carbide, used in the abrasive waterjet for cutting, the reflected jet will in time erode away even a superhard material carrier. Since a CVDD tube is brittle and easily damaged by even minor collision with a workpiece, the outlet end of a CVDD focus tube 22 should ideally be surrounded by an outlet wear protection element 90, made from highly erosion-resistant material, that can also sustain at least moderate impact loads. Reflected and ricocheting abrasive particles will rapidly erode away any encasing/holding material 84 that might extend into gap 92 between the composite focus tube 80 adjacent its outlet end 11 and the surrounding outlet wear protection element 90. As a result, any encasing/holding material 84 extending into gap 92 will not survive and there is hence little benefit in filling the gap 92 with such encasing/holding material 84. The ratio of the width of gap 92 to its length can be selected such that the energy of any reflected abrasive particles entering the gap 92 is dissipated by impacts before such abrasive particles reach the encasing/holding material 84, further up the fourth composite focus tube 80. The outlet wear protection element 90 is mounted to the holder 81 by a relatively weak adhesive spread over mutual contact surface 91, by a push fit or interference fit, by a threaded joint, or by any other means that allows the outlet wear protection element 90 to be separated from the fourth composite focus tube 80, to allow for its replacement by a replacement outlet wear protection element 90, once damage thereto becomes excessive. Alternatively, a band or other retaining means can be used around an exterior of the holder 81 and the outlet wear protection element 90, adjacent a circumferential line 89 where they meet externally.

The inlet protection element 85 is also made of erosion/resistant material, and can be a press-fit or can be retained in the holder 81 by other separable fastening arrangements, and acts to prevent physical or erosion damage to the encasing/holding material 82 and to the inlet end of the CVDD focus tube 22. The CVDD focus tube 22 can also be vulnerable to physical or erosion damage where its walls have been thinned by the formation of the tapering inlet 5, and the inlet protection element 85 also provides some protection against such damage and erosion.

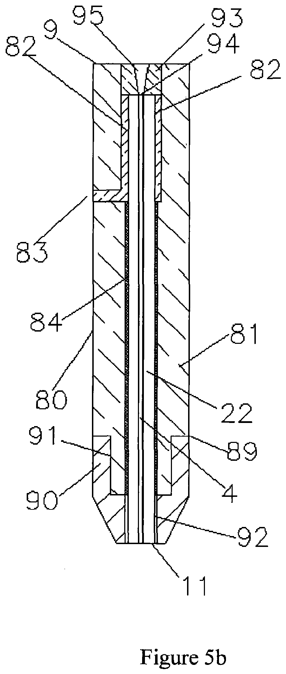

Figure 5b shows an alternative arrangement, with a second inlet protection element 93. This has a generally contracting or tapering bore 95, which performs the function of the tapering inlet 5 of the CVDD tube 22 illustrated in Figure 5a. Where the generally contracting bore 95 in the second inlet protection element 93 and the constant-diameter through-bore 4 of the CVDD tube 22 meet, a diameter of the contracting bore 95 is preferably between 2% and 5% smaller than the corresponding diameter of the bore 4 of the CVDD tube 22. This slight "overhang" of the material of the inlet protection element 93 helps to protect the proximal/inlet end of the CVDD tube 22. The second inlet protection element 93 is preferably made from diamond, and may have an outside diameter that is equal to or greater than an outside diameter of holder 81.

As well as a passage 83 for the injection of encasing/holding material 82, it would be possible to machine a generally radial passageway (not shown) through the second inlet protection element 93 so that abrasive particles in a carrier fluid can be delivered into the contracting bore 95, for their entrainment into a waterjet projected along the composite focus tube 80.

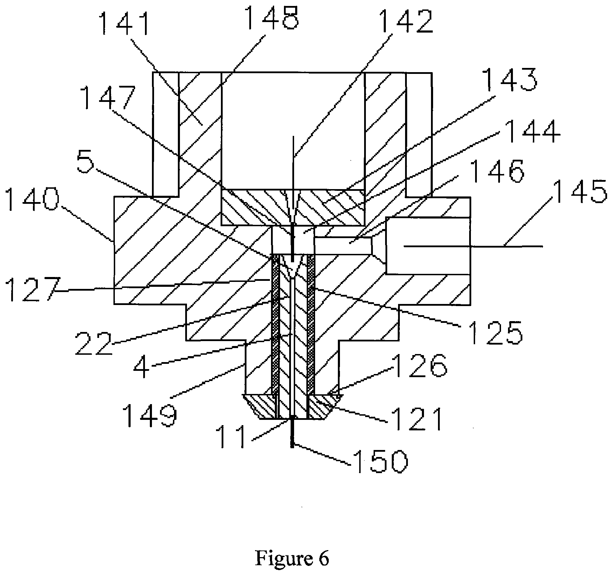

Figure 6 shows an entire cutting head 140 of an abrasive waterjet cutting tool, with a main body 141 which also acts as a holder for the CVDD tube 22. The process of encasing and holding the CVDD tube 22 in cutting head body 141 is similar to that described above in respect of Figure 3. However, the cutting head body 141 comprises an inlet bore 148, at an outer end of which is located a waterjet nozzle 143, to generate the waterjet projected into the CVDD focus tube 22. The inlet bore 148 may be used to receive and confine a first guide (not shown), which cooperates with a second guide (not shown) located over a precise outer diameter reference projection 149 at an outlet end of the cutting head body 141. These guides define and fix a centreline axis of the bore 4 of the CVDD tube 22 at its inlet and outlet ends respectively. The CVDD tube 22 is thus held in position within passage 127 through the body 140 while encasing/holding material 125 sets/solidifies around it.

The cutting head 140 is provided with a protector 121 at its outlet end 126, made of a superhard material such as polycrystalline diamond or tungsten carbide. The protector 121 may be soldered or brazed to the cutting head body 141 before the CVDD tube 22 is mounted within the body 141. It is important that the relatively soft, malleable and/or resilient encasing/holding material 125 does not extend into the gap between an outer surface of the outlet portion of the CVDD focus tube 22 and the corresponding aperture through the protector 121 that is provided to receive said outlet portion of the CVDD focus tube 22.

The cutting head 140 shown in Figure 6 is particularly suited for generating a cutting jet 150 by entraining a slurry of abrasive particles suspended in water into the waterjet. Ultra high pressure water from a source 142 is discharged through the waterjet nozzle 143 to form a waterjet 147. Abrasive particles in a carrier fluid are passed from a respective source 145 through a passageway 146 in the cutting head body 141 into a chamber 144. The waterjet 147 traverses this chamber 144, entraining these abrasive particles as it passes from the chamber 144 into the tapering inlet 5 of the CVDD focus tube 22 and onwards into the bore 4. Within the bore 4 of the CVDD focus tube 22, momentum is exchanged between the waterjet and the abrasive particles, producing a cutting jet 150 emerging from the outlet end 11 of the CVDD focus tube 22. The protector 121, protects the CVDD focus tube 22 from physical impact damage and protects the body 141 of the cutting head 140 from erosion by reflected and ricocheting abrasive particles.

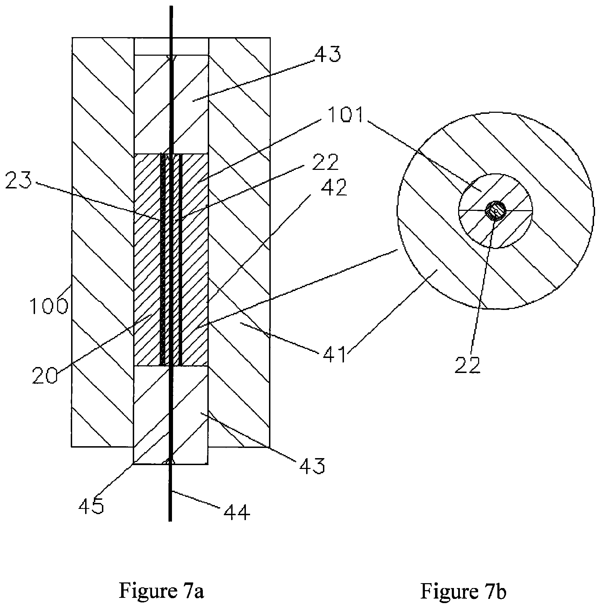

Figures 7a and 7b show an alternative method of encasing a CVDD focus tube 22, embodying the present invention. This comprises positioning and holding a CVDD tube 22 in a mould, while an encasing material solidifies, sets, cures or otherwise hardens around the CVDD focus tube 22. Figure 7a shows a second jig 100, which is a variation of the jig 40 shown in Figure 3. Instead of a holder 3 with a passage 23 extending through it to receive the CVDD tube 22, a two part split mould 101 is used (best seen in Figure 7b). The mould 101 is made from a material to which the encasing material in question does not adhere, or is coated with a release agent or the like, to ensure that the encasing material does not adhere to the mould 101. The alignment of the centreline axis of the bore 4 of the CVDD focus tube 22 and the covering of the external surface of the CVDD focus tube 22 with the encasing material take place essentially as described above in respect of Figure 3. However, once the encasing material has solidified, cured or set, the split mould 101 and the CVDD focus tube 22 are removed from the second jig 100 and the split mould 101 is separated, leaving the CVDD focus tube 22 encased in the encasing material. This can then be inserted into a suitably-dimensioned passage 23 extending through a holder such as the holder 3 of Figure 1, with the assistance of a further amount of adhesive as holding material.

As an example of the resistance of composite CVDD diamond focus tubes embodying the present invention, a composite CVDD focus tube 22 was selected, 6mm in length with a bore diameter of 0.125mm. In a conventional abrasive waterjet cutting tool using garnet abrasive, wear rates were so low that they were hardly detectable, and so further tests were carried out using 23 µm mean diameter silicon carbide as abrasive. After eight hours of cutting time, the diameter of the outlet end of the CVDD focus tube 22 had grown to 0.137mm, and was still essentially round and suitable for further cutting operations. Under the identical test conditions, a 5mm long tungsten carbide tube with a bore diameter of 0.125mm grew in diameter so rapidly that before test conditions were even stabilised, the bore diameter had grown to an average of 0.190mm and was markedly out of round.

This invention thus provides a means of employing CVDD focus tubes in practice, giving such major leaps forward in performance and durability, without the problems found hitherto, as a result of the CVDD focus tubes being too brittle, particularly when rigidly mounted in their respective holder. The use of high-performance polymeric adhesives or of low-melting point metals and alloys allows the rapid and accurate assembly of precisely-unlined composite focus tubes, without the casing/holding materials exerting additional stresses on the CVDD tube on solidification. Not only do the relative softness and resilience of such materials, relative to a remainder of the cutting head serve to isolate the CVDD tube from shocks, but it also acts to obviate the formation of local stress centres which might lead to sudden failure of the CVDD tube. Although in principle such materials might be considered to establish a weak point in the structure of the cutting head, in practice it is straightforward to incorporate structural features that prevent abrasive particles and the like attacking these points in the structure. This mounting approach also allows considerable variation in the profile of the CVDD tube, for example to generate a non-circular section abrasive waterjets.

## Claims

1. A composite chemical vapour deposition diamond (CVDD) focus tube (1, 20, 80, 140, 200) for a cutting head of an abrasive waterjet cutting machine, said composite CVDD focus tube comprising:
an elongate CVDD tube (2, 22, 201) having a smooth through bore (4, 204) extending longitudinally between an inlet end of the CVDD tube and an outlet end of the CVDD tube; and
holder means (3, 21, 81, 141, 203) having an elongate passage (6, 23, 127) extending through the holder means to accommodate the elongate CVDD tube;
**characterised in that** the elongate CVDD tube is encased within said elongate passage by a solid castable material (7, 82, 84, 125, 207), said castable material being deliverable into said elongate passage as a liquid for subsequent solidification.

2. A composite CVDD focus tube as claimed in claim 1, **characterised in that** said castable material (7, 82, 84, 125, 207) solidifies by undergoing chemical reaction.

3. A composite CVDD focus tube as claimed in either claim 1 or claim 2, **characterised in that** said castable material (7, 82, 84, 125, 207) comprises a plastics material curable *in situ* within said elongate passage (6, 23, 127).

4. A composite CVDD focus tube as claimed in any one of the preceding claims, **characterised in that** said castable material (7, 82, 84, 125, 207) comprises an adhesive composition.

5. A composite CVDD focus tube as claimed in claim 1, **characterised in that** said castable material (7, 82, 84, 125, 207) solidifies by undergoing a phase change on cooling.

6. A composite CVDD focus tube as claimed in claim 5, **characterised in that** said castable material (7, 82, 84, 125, 207) comprises a metal.

7. A composite CVDD focus tube as claimed in claim 6, **characterised in that** said castable material (7, 82, 84, 125, 207) comprises a fusible alloy having a melting point of 200°C or below.

8. A composite CVDD focus tube as claimed in any one of the preceding claims, **characterised in that** the through bore (4, 204) of the elongate CVDD tube (2, 22, 201) comprises a generally conical portion (5, 205, 215) tapering from said inlet end to meet a remainder of the bore (4, 204), said remainder of the bore having a substantially constant diameter.

9. A composite CVDD focus tube as claimed in any one of the preceding claims, **characterised in that** the elongate CVDD tube (2, 22, 201) is so held within the elongate passage (6, 23, 127) of the holder means (3, 21, 81, 141, 203) that a longitudinal axis of the through bore (4, 204) of the elongate CVDD tube coincides with a reference centreline of the holder means.

10. A composite CVDD focus tube as claimed in any one of the preceding claims, **characterised in that** an outer surface of the elongate CVDD tube (2, 22, 201) is rough and faceted, so as to engage with the castable material (7, 82, 84, 125, 207,) encasing the elongate CVDD tube within the elongate passage (6, 23, 127).

11. A composite CVDD focus tube as claimed in any one of the preceding claims, **characterised in that** the castable material (7, 82, 84, 125, 207) is selected such that when solidified around the elongate CVDD tube (2, 22, 201), it holds the elongate CVDD tube without exerting stress thereon.

12. A composite CVDD focus tube as claimed in any one of the preceding claims, **characterised in that** the diamond of the elongate CVDD tube (2, 22, 201) is doped, to render the diamond electrically conductive.

13. A composite CVDD focus tube as claimed in any one of the preceding claims, **characterised in that** the through bore (4, 204) of the elongate CVDD tube (2, 22, 201) has an internal profile that varies along its length towards the outlet end of the CVDD tube, so as to project a non-circular section waterjet from said outlet end.

14. A method of making a composite CVDD focus tube (1, 20, 80, 140, 200) for a cutting head of an abrasive waterjet cutting machine, comprising the steps of:
providing an elongate CVDD tube (2, 22, 201) having a smooth through bore (4, 204) extending longitudinally between an inlet end of the CVDD tube and an outlet end of the CVDD tube; **characterised by**
providing holder means (3, 21, 41, 141, 203) having an elongate passage (6, 23, 127) extending through the holder means to accommodate the elongate CVDD tube;
locating the elongate CVDD tube into said elongate passage; and
delivering a castable material (7, 82, 84, 125, 207) in liquid form into the elongate passage, external to the elongate CVDD tube, then causing the castable material to solidify.

15. A method of making a composite CVDD focus tube as claimed in claim 14, **characterised in that** the elongate CVDD tube (2, 22, 201) is located within said elongate passage (6, 23, 127) in the holder means (3, 21, 41, 141, 203) such that a longitudinal axis of the through bore (4, 204) of the elongate CVDD tube coincides with a reference centreline of the holder means, and is held in this location until the castable material (7, 82, 84, 125, 207) has solidified.

## Patentansprüche

1. Chemisches Gasphasenabscheidungs-Diamant (CVDD-)Verbund-Fokussierrohr (1, 20, 80, 140, 200) für einen Schneidkopf einer abrasiven Wasserstrahlschneidmaschine, das CVDD-Verbund-Fokussierrohr Folgendes umfassend:
ein längliches CVDD-Rohr (2, 22, 201) mit einer glatten Durchgangsbohrung (4, 204), die sich in Längsrichtung zwischen einem Einlass-Ende des CVDD-Rohres und einem Auslass-Ende des CVDD-Rohres erstreckt; und
Haltevorrichtungen (3, 21, 81, 141, 203) mit einem länglichen Durchgang (6, 23, 127), der durch die Haltevorrichtungen verläuft, um das längliche CVDD-Rohr aufzunehmen;
**dadurch gekennzeichnet, dass** das langgestreckte CVDD-Rohr innerhalb des besagten länglichen Durchgangs von einem festen gießbaren Material (7, 82, 84, 125, 207) umhüllt ist, wobei das besagte gießbare Material als eine Flüssigkeit zur anschließenden Verfestigung in den langgestreckten Durchgang eingebracht werden kann.

2. CVDD-Verbund-Fokussierrohr nach Anspruch 1, **dadurch gekennzeichnet, dass** das besagte gießbare Material (7, 82, 84, 125, 207) durch eine chemische Reaktion erstarrt.

3. CVDD-Verbund-Fokussierrohr nach Anspruch 1 oder 2, **dadurch gekennzeichnet, dass** das besagte gießbare Material (7, 82, 84, 125, 207) ein Kunststoffmaterial umfasst, das *in situ* innerhalb des besagten länglichen Durchgangs (6, 23, 127) aushärtbar ist.

4. CVDD-Verbund-Fokussierrohr nach einem der vorhergehenden Ansprüche, **dadurch gekennzeichnet, dass** das besagte gießbare Material (7, 82, 84, 125, 207) eine Klebstoffzusammensetzung umfasst.

5. CVDD-Verbund-Fokussierrohr nach Anspruch 1, **dadurch gekennzeichnet, dass** das besagte gießbare Material (7, 82, 84, 125, 207) beim Abkühlen durch eine Phasenänderung erstarrt.

6. CVDD-Verbund-Fokussierrohr nach Anspruch 5, **dadurch gekennzeichnet, dass** das besagte gießbare Material (7, 82, 84, 125, 207) ein Metall umfasst.

7. CVDD-Verbund-Fokussierrohr nach Anspruch 6, **dadurch gekennzeichnet, dass** das besagte gießbare Material (7, 82, 84, 125, 207) eine schmelzbare Legierung mit einem Schmelzpunkt von 200 °C oder darunter umfasst.

8. CVDD-Verbund-Fokussierrohr nach einem der vorhergehenden Ansprüche, **dadurch gekennzeichnet, dass** die Durchgangsbohrung (4, 204) des länglichen CVDD-Rohres (2, 22, 201) einen allgemein konischen Abschnitt (5, 205, 215) umfasst, der sich von dem Einlassende aus verjüngt, so dass er auf einen Rest der Bohrung (4, 204) trifft, wobei der Rest der Bohrung einen im Wesentlichen konstanten Durchmesser hat.

9. CVDD-Verbund-Fokussierrohr nach einem der vorhergehenden Ansprüche, **dadurch gekennzeichnet, dass** das längliche CVDD-Rohr (2, 22, 201) innerhalb des länglichen Durchgangs (6, 23, 127) der Haltevorrichtungen (3, 21, 81, 141, 203) so gehalten wird, dass eine Längsachse der Durchgangsbohrung (4, 204) des länglichen CVDD-Rohres mit einer Bezugsmittellinie der Haltevorrichtungen zusammenfällt.

10. CVDD-Verbund-Fokussierrohr nach einem der vorstehenden Ansprüche, **dadurch gekennzeichnet, dass** eine Außenfläche des länglichen CVDD-Rohres (2, 22, 201) rau und facettiert ist, so dass sie mit dem gießbaren Material (7, 82, 84, 125, 207) in Eingriff kommt, mit dem das längliche CVDD-Rohr innerhalb des länglichen Durchgangs (6, 23, 127) umhüllt ist.

11. CVDD-Verbund-Fokussierrohr nach einem der vorhergehenden Ansprüche, **dadurch gekennzeichnet, dass** das gießbare Material (7, 82, 84, 125, 207) so ausgewählt ist, dass es, wenn es um das längliche CVDD-Rohr (2, 22, 201) herum erstarrt, das längliche CVDD-Rohr hält, ohne auf dieses eine Spannung auszuüben.

12. CVDD-Verbund-Fokussierrohr nach einem der vorhergehenden Ansprüche, **dadurch gekennzeichnet, dass** der Diamant des länglichen CVDD-Rohres (2, 22, 201) dotiert ist, um den Diamanten elektrisch leitfähig zu machen.

13. CVDD-Verbund-Fokussierrohr nach einem der vorhergehenden Ansprüche, **dadurch gekennzeichnet, dass** die Durchgangsbohrung (4, 204) des länglichen CVDD-Rohres (2, 22, 201) ein Innenprofil aufweist, das sich entlang seiner Länge zum Auslass-Ende des CVDD-Rohres hin verändert, so dass ein Wasserstrahl mit nicht-kreisförmigem Querschnitt aus dem Auslass-Ende ausgestoßen wird.

14. Verfahren zur Herstellung eines CVDD-Verbund-Fokussierrohres (1, 20, 80, 140, 200) für einen Schneidkopf einer abrasiven Wasserstrahlschneidmaschine, folgende Schritte umfassend:
Bereitstellen einer länglichen CVDD-Röhre (2, 22, 201) mit einer glatten Durchgangsbohrung (4, 204), die in Längsrichtung zwischen einem Einlassende des CVDD-Rohres und einem Auslassende des CVDD-Rohres verläuft; **gekennzeichnet durch** Bereitstellen von Haltevorrichtungen (3, 21, 41, 141, 203) mit einem länglichen Durchgang (6, 23, 127), der durch die Haltevorrichtung verläuft, um das längliche CVDD-Rohr aufzunehmen;
Positionieren des länglichen CVDD-Rohres in dem länglichen Durchgang; und
Zuführen eines gießbaren Materials (7, 82, 84, 125, 207) in flüssiger Form in den länglichen Durchgang außerhalb des länglichen CVDD-Rohres, wodurch das gießbare Material erstarrt.

15. Verfahren zur Herstellung eines CVDD-Verbund-Fokussierohres nach Anspruch 14, **dadurch gekennzeichnet, dass** das längliche CVDD-Rohr (2, 22, 201) innerhalb des besagten länglichen Durchgangs (6, 23, 127) in den Haltervorrichtungen (3, 21, 41, 141, 203) so angeordnet ist, dass eine Längsachse der Durchgangsbohrung (4, 204) des länglichen CVDD-Rohres mit einer Bezugsmittellinie der Haltervorrichtungen zusammenfällt und an dieser Stelle gehalten wird, bis das gießbare Material (7, 82, 84, 125, 207) erstarrt ist.

## Revendications

1. Tube de focalisation composite en diamant de dépôt chimique en phase vapeur (CVDD) (1, 20, 80, 140, 200) pour une tête de coupe d'une machine de coupe à jet d'eau abrasif, ledit tube de focalisation composite CVDD comprenant :
un tube CVDD allongé (2, 22, 201) ayant un alésage traversant lisse (4, 204) s'étendant longitudinalement entre une extrémité d'entrée du tube CVDD et une extrémité de sortie du tube CVDD ; et
des moyens de support (3, 21, 81, 141, 203) ayant un passage allongé (6, 23, 127) s'étendant à travers les moyens de support pour loger le tube CVDD allongé ;
**caractérisé en ce que** le tube CVDD allongé est enfermé dans ledit passage allongé par un matériau moulable solide (7, 82, 84, 125, 207), ledit matériau moulable pouvant être délivré dans ledit passage allongé sous forme de liquide pour une solidification ultérieure.

2. Tube de focalisation CVDD composite selon la revendication 1, **caractérisé en ce que** ledit matériau moulable (7, 82, 84, 125, 207) se solidifie en subissant une réaction chimique.

3. Tube de focalisation composite CVDD selon la revendication 1 ou la revendication 2, **caractérisé en ce que** ledit matériau moulable (7, 82, 84, 125, 207) comprend un matériau plastique durcissable *in situ* à l'intérieur dudit passage allongé (6, 23, 127).

4. Tube de focalisation CVDD composite selon l'une quelconque des revendications précédentes, **caractérisé en ce que** ledit matériau moulable (7, 82, 84, 125, 207) comprend une composition adhésive.

5. Tube de focalisation CVDD composite selon la revendication 1, **caractérisé en ce que** ledit matériau moulable (7, 82, 84, 125, 207) se solidifie en subissant un changement de phase lors du refroidissement.

6. Tube de focalisation CVDD composite selon la revendication 5, **caractérisé en ce que** ledit matériau moulable (7, 82, 84, 125, 207) comprend un métal.

7. Tube de focalisation CVDD composite selon la revendication 6, **caractérisé en ce que** ledit matériau moulable (7, 82, 84, 125, 207) comprend un alliage fusible ayant un point de fusion de 200 °C ou moins.

8. Tube de focalisation CVDD composite selon l'une quelconque des revendications précédentes, **caractérisé en ce que** l'alésage traversant (4, 204) du tube CVDD allongé (2, 22, 201) comprend une partie généralement conique (5, 205, 215) s'effilant depuis ladite extrémité d'entrée pour rencontrer un reste de l'alésage (4, 204), ledit reste de l'alésage ayant un diamètre sensiblement constant.

9. Tube de focalisation CVDD composite selon l'une quelconque des revendications précédentes, **caractérisé en ce que** le tube CVDD allongé (2, 22, 201) est ainsi maintenu à l'intérieur du passage allongé (6, 23, 127) des moyens de support (3, 21, 81, 141, 203) qu'un axe longitudinal de l'alésage traversant (4, 204) du tube CVDD allongé coïncide avec une ligne médiane de référence des moyens de support.

10. Tube de focalisation CVDD composite selon l'une quelconque des revendications précédentes, **caractérisé en ce qu'**une surface extérieure du tube CVDD allongé (2, 22, 201) est rugueuse et à facettes, de manière à s'engager avec le matériau moulable (7, 82, 84, 125, 207,) enfermant le tube CVDD allongé dans le passage allongé (6, 23, 127).

11. Tube de focalisation CVDD composite selon l'une quelconque des revendications précédentes, **caractérisé en ce que** le matériau moulable (7, 82, 84, 125, 207) est choisi de telle sorte que lorsqu'il est solidifié autour du tube CVDD allongé (2, 22, 201), il maintient le tube CVDD allongé sans exercer de contrainte sur celui-ci.

12. Tube de focalisation CVDD composite selon l'une quelconque des revendications précédentes, **caractérisé en ce que** le diamant du tube CVDD allongé (2, 22, 201) est dopé, afin de rendre le diamant électriquement conducteur.

13. Tube de focalisation CVDD composite selon l'une quelconque des revendications précédentes, **caractérisé en ce que** l'alésage traversant (4, 204) du tube CVDD allongé (2, 22, 201) présente un profil interne qui varie sur sa longueur vers l'extrémité de sortie du tube CVDD, de manière à projeter un jet d'eau de section non circulaire à partir de ladite extrémité de sortie.

14. Procédé de fabrication d'un tube de focalisation CVDD composite (1, 20, 80, 140, 200) pour une tête de coupe d'une machine de coupe à jet d'eau abrasif, comprenant les étapes suivantes :
la fourniture d'un tube CVDD allongé (2, 22, 201) ayant un alésage traversant lisse (4, 204) s'étendant longitudinalement entre une extrémité d'entrée du tube CVDD et une extrémité de sortie du tube CVDD ; **caractérisé par**
la fourniture des moyens de support (3, 21, 41, 141, 203) ayant un passage allongé (6, 23, 127) s'étendant à travers les moyens de support pour loger le tube CVDD allongé ;
le placement du tube CVDD allongé dans ledit passage allongé ; et
la livraison d'un matériau moulable (7, 82, 84, 125, 207) sous forme liquide dans le passage allongé, extérieur au tube CVDD allongé, puis la provocation de la solidification du matériau moulable.

15. Procédé de fabrication d'un tube de focalisation CVDD composite selon la revendication 14, **caractérisé en ce que** le tube CVDD allongé (2, 22, 201) est situé à l'intérieur dudit passage allongé (6, 23, 127) dans les moyens de support (3, 21, 41, 141, 203) de telle sorte qu'un axe longitudinal de l'alésage traversant (4, 204) du tube CVDD allongé coïncide avec une ligne médiane de référence des moyens de support, et est maintenu à cet emplacement jusqu'à ce que le matériau moulable (7, 82, 84, 125, 207) se soit solidifié.
